# EUROPÄISCHE PATENTSCHRIFT

(11) **EP 2 300 356 B1**
(45) Veröffentlichungstag und Bekanntmachung des Hinweises auf die Patenterteilung: **27.12.2017**
(21) Anmeldenummer: 09761543.9
(22) Anmeldetag: 21.04.2009
(51) Int. Cl.: B81C 1/00

(54) **VERFAHREN ZUR HERSTELLUNG EINER MIKROMECHANISCHEN MEMBRANSTRUKTUR MIT ZUGANG VON DER SUBSTRATRÜCKSEITE**
METHOD FOR PRODUCING A MICROMECHANICAL MEMBRANE STRUCTURE WITH ACCESS FROM THE REAR OF THE SUBSTRATE
PROCÉDÉ POUR PRODUIRE UNE STRUCTURE MEMBRANAIRE MICRO-MÉCANIQUE COMPORTANT UN ACCÈS PAR LE CÔTÉ ARRIÈRE DU SUBSTRAT

(30) Priorität: 10.06.2008 DE 102008002332
(43) Veröffentlichungstag der Anmeldung: 30.03.2011
(73) Patentinhaber: Robert Bosch GmbH, 70442 Stuttgart (DE)
(72) Erfinder: KRAMER, Torsten, 72827 Wannweil (DE); AHLES, Marcus, 72793 Pfullingen (DE); GRUNDMANN, Armin, 72762 Reutlingen (DE); KNESE, Kathrin, 70374 Stuttgart (DE); BENZEL, Hubert, 72124 Pliezhausen (DE); SCHUERMANN, Gregor, 72766 Reutlingen (DE); ARMBRUSTER, Simon, 72810 Gomaringen (DE)
(86) Internationale Anmeldenummer: PCT/EP2009/054698
(87) Internationale Veröffentlichungsnummer: WO 2009/149980

(56) Entgegenhaltungen:
- EP-A- 1 167 934
- WO-A-2009/127455
- DE-A1-102004 015 444
- DE-A1-102004 036 035
- DE-A1-102005 042 648
- DE-A1-102006 024 668
- US-A1- 2006 057 755

## Beschreibung

### Stand der Technik

Die Erfindung betrifft ein Verfahren zur Herstellung einer mikromechanischen Membranstruktur mit Zugang von der Substratrückseite sowie ein entsprechendes Halbleiterbauelement.

Das Verfahren geht von einem p-dotierten Si-Substrat aus und umfasst folgende Prozessschritte:
- n-Dotierung mindestens eines zusammenhängenden gitterförmigen Bereichs der Substratoberfläche,
- porös Ätzen eines Substratbereichs unterhalb der n-dotierten Gitterstruktur,
- Erzeugen einer Kaverne in diesem Substratbereich unterhalb der n-dotierten Gitterstruktur und
- Aufwachsen einer monokristallinen Silizium-Epitaxieschicht auf der n-dotierten Gitterstruktur.

Bei der Herstellung von Sensorelementen zur Relativdruck- bzw. Differenzdruckmessung wird üblicherweise ein Rückseitenzugang zur Membranstruktur erzeugt, der die beidseitige Druckbeaufschlagung der Sensormembran ermöglicht. Aber auch Sensorelemente zur Absolutdruckmessung werden für bestimmte Anwendungen mit einem Rückseitenzugang zur Druckbeaufschlagung der Sensormembran versehen. Bei Einsatz eines Absolutdrucksensors in sogenannten "Harsh-Environments" kann dadurch vermieden werden, dass die Chip-Vorderseite mit dem Messmedium in Kontakt tritt.

In der DE 10 2004 036 035 A1 wird ein Verfahren zur Herstellung eines Halbleiterbauelements mit einer Membranstruktur und einem Rückseitenzugang zu dieser Membranstruktur beschrieben. Das bekannte Verfahren geht von einem p-dotierten monokristallinen Si-Substrat aus. Zunächst wird ein zusammenhängender gitterförmiger Bereich der Substratoberfläche mit einer n-Dotierung versehen. Dann wird ein Substratbereich unterhalb der so entstandenen n-dotierten Gitterstruktur porös geätzt, wobei die n-dotierte Gitterstruktur durch diesen Ätzprozess nicht angegriffen wird. In einem anschließenden Epitaxieprozess wird nun eine geschlossene monokristalline Si-Epitaxieschicht auf der n-dotierten Gitterstruktur erzeugt.
In einer ersten Variante des bekannten Verfahrens lagert sich das poröse Silizium während des Epitaxieprozesses und eines weiteren Temperschritts so um, dass eine Kaverne unterhalb der n-dotierten Gitterstruktur und der aufgewachsenen Epitaxieschicht entsteht. Bei einer zweiten Variante des bekannten Verfahrens wird noch vor dem Epitaxieprozess eine Kaverne unterhalb der n-dotierten Gitterstruktur erzeugt. Bei dieser Variante wird die Kavernenwandung - soweit sie vor der Epitaxie besteht - durch ein thermisches Oxid gegen das Aufwachsen von Siliziummaterial während des Epitaxieprozesses geschützt. Durch eine entsprechende Prozessführung wächst die Epitaxieschicht auch lateral auf der Gitterstruktur auf, so dass sie die Gitteröffnungen und damit auch die Kaverne verschließt. Diese Bereiche der Epitaxieschicht vervollständigen die Kavernenwandung und sind - entsprechend der Prozessführung - nicht mit Oxid beschichtet.
Eine dritte Variante des bekannten Verfahrens sieht vor, das poröse Silizium unterhalb der n-dotierten Gitterstruktur zu oxidieren, um zu verhindern, dass sich das poröse Silizium während der Epitaxie umlagert. Die Kaverne wird hier erst nach dem Aufbringen der Epitaxieschicht durch Herauslösen des porösen Siliziumoxids erzeugt. Dies kann entweder über eine Zugangsöffnung erfolgen, die nachträglich in die Epitaxieschicht eingebracht wird, oder auch über ein Zugangsloch in der Substratrückseite, das dann auch als Rückseitenzugang zur Membranstruktur genutzt werden kann. Ein weiteres Verfahren zur Herstellung eines mikromechanischen Bauelements ist aus dem EP 1 167 934 A1 bekannt.

### Offenbarung der Erfindung

Mit der vorliegenden Erfindung wird eine Weiterentwicklung des bekannten Verfahrens vorgeschlagen, mit der einfach, kostengünstig und unter Einhaltung genauer Herstellungstoleranzen mikromechanische Bauelemente mit einer Membranstruktur und einem Rückseitenzugang zu dieser Membranstruktur hergestellt werden können.

Das erfindungsgemäße Verfahren ist dadurch gekennzeichnet,
- dass mindestens eine Öffnung der n-dotierten Gitterstruktur so dimensioniert wird, dass sie durch die aufwachsende erste Epitaxieschicht nicht verschlossen wird sondern eine Zugangsöffnung zu der Kaverne bildet;
- dass auf der Kavernenwandung eine Oxidschicht erzeugt wird;
- dass ein Rückseitenzugang zur Kaverne erzeugt wird, wobei die Oxidschicht auf der Kavernenwandung als Ätzstoppschicht dient; und
- dass die Oxidschicht im Bereich der Kaverne entfernt wird, so dass ein Rückseitenzugang zu der über der Kaverne ausgebildeten Membranstruktur entsteht.

Das erfindungsgemäße Verfahren beruht auf einer geschickten Kombination von bewährten oberflächenmikromechanischen Prozessblöcken mit einem von der Substratrückseite ausgehenden Standard-Ätzverfahren für das Bulk-Silizium. Dabei wird eine Oxidschicht auf der Kavernenwandung, die mit Techniken der Oberflächenmikromechanik erzeugt worden ist, als Ätzstoppschicht bei der Prozessierung des Bulk-Siliziums genutzt. Insbesondere die Membranstruktur wird durch diese auf der Unterseite ausgebildete Oxidschicht zuverlässig gegen den rückseitigen Ätzangriff geschützt. Jeder einzelne Verfahrensschritt des erfindungsgemäßen Verfahrens lässt sich durch eine bekannte, gut handhabbare, gut kontrollierbare und deshalb insgesamt kostengünstige Prozessfolge darstellen. Zudem bietet das erfindungsgemäße Verfahren eine hohe Designfreiheit im Hinblick auf Form und Größe der Membranstruktur, wobei diese sich mit definierter Dicke und definierten Abmessungen herstellen lässt. Dies kann zur Optimierung der Bauelementstruktur für verschiedene Anwendungen genutzt werden.
Mit Hilfe des erfindungsgemäßen Verfahrens werden bevorzugt durchgängig monokristalline Siliziummembranen mit definierten Materialparametern erzeugt. Derartige Membranen zeichnen sich durch eine hohe Langzeitstabilität aus und ermöglichen die monolithische Integration von Schaltungselementen, wie beispielsweise Piezowiderständen zur Signalerfassung. Da die Prozessschritte des erfindungsgemäßen Verfahrens CMOSkompatibel sind, kann es einfach durch eine Prozessfolge zur monolithischen Integration einer Auswerteschaltung ergänzt werden.

Neben dem Herstellungsverfahren wird auch ein so gefertigtes Halbleiterbauelement mit einer mikromechanischen Membranstruktur über einer Kaverne beansprucht, die in einem p-dotierten Si-Substrat ausgebildet ist und einen Rückseitenzugang aufweist. Verfahrensbedingt umfasst die Membranstruktur eine n-dotierte Gitterstruktur, auf der mindestens eine erste Epitaxieschicht aufgewachsen ist. Das erfindungsgemäße Herstellungsverfahren bedingt außerdem, dass die laterale Ausdehnung der Kaverne unter der Membranstruktur allseitig größer ist als die Mündungsöffnung des Rückseitenzugangs in der Kavernenwandung. Dieses strukturelle Merkmal ergibt sich aus der erfindungsgemäßen Verwendung der Oxidschicht auf der Kavernenwandung als Ätzstoppschicht, unabhängig davon, ob der Rückseitenzugang durch Trenchen, KOH-Ätzen oder mit Hilfe eines anderen Ätzverfahrens erzeugt wird.

Wie bereits erwähnt, sieht das erfindungsgemäße Verfahren vor, die Kavernenwandung mit einer Oxidschicht zu versehen. Diese Oxidschicht wird erfindungsgemäß erst nach dem Aufwachsen einer ersten Epitaxieschicht auf der n-dotierten Gitterstruktur erzeugt, die zusammen die Kaverne begrenzen und die unterste Membranschicht bilden. Dementsprechend überdeckt die Oxidschicht die Membranunterseite vollständig. Grundsätzlich können im Rahmen des erfindungsgemäßen Verfahrens dafür unterschiedliche Oxidationsprozesse angewendet werden. So kann die Oxidschicht auf der Kavernenwandung beispielsweise durch konforme Abscheidung von Siliziumoxid auf der Epitaxieschicht erzeugt werden. Dabei dringt das Siliziumoxid über die Zugangsöffnung in der Epitaxieschicht und der n-dotierten Gitterstruktur auch in die Kaverne ein und kleidet diese aus. In einer besonders vorteilhaften Variante des erfindungsgemäßen Verfahrens wird die Oxidschicht auf der Kavernenwandung jedoch durch thermische Oxidation erzeugt, wobei der dafür erforderliche Sauerstoff über die Zugangsöffnung in der Epitaxieschicht und der n-dotierten Gitterstruktur in die Kaverne gelangt.

Soll eine geschlossene Membranstruktur erzeugt werden, wie sie für viele Anwendungen erforderlich ist, so muss die Zugangsöffnung in der Epitaxieschicht geschlossen werden. Dazu kann der Oxidationsprozess zum Erzeugen der Oxidschicht auf der Kavernenwandung einfach solange fortgesetzt werden, bis die Zugangsöffnung durch einen Oxidpfropfen verschlossen ist. Im Falle einer thermischen Oxidation ist dies relativ zeit- und energieaufwendig. In einer vorteilhaften Variante des erfindungsgemäßen Verfahrens wird die Zugangsöffnung durch Abscheiden einer oder auch mehrerer dielektrischer, polykristalliner oder epitaktischer (Silizium-)Schichten auf der Epitaxieschicht verschlossen, wie z.B. eine zusätzliche Oxidschicht.

Wie bereits erwähnt, sind durchgängig monokristalline Siliziummembranen sowohl im Hinblick auf ihre mechanischen Eigenschaften als auch im Hinblick auf eine mögliche Integration von Schaltungselementen von Vorteil. Deshalb wird entsprechend einer vorteilhaften Variante des erfindungsgemäßen Verfahrens auf der ersten Epitaxieschicht mindestens eine weitere Silizium-Epitaxieschicht erzeugt, die die verschlossene Zugangsöffnung überdeckt. Dabei können die Prozessparameter so gewählt werden, dass über der verschlossenen Zugangsöffnung ein polykristalliner Bereich entsteht, der von monokristallinem Silizium überwachsen wird, oder auch so, dass die verschlossene Zugangsöffnung lateral von monokristallinem Silizium überwachsen wird, so dass die weitere Silizium-Epitaxieschicht durchgängig monokristallin ist.

Bei einer weiteren Variante des erfindungsgemäßen Verfahrens wird die hohe Designfreiheit ausgenutzt, um die Zugangsöffnungen in der n-dotierten Gitterstruktur und der darauf aufgewachsenen Epitaxieschicht nicht im Membranbereich über der Kaverne anzuordnen sondern über Kanälen, die in die Kaverne münden. Dazu wird zunächst unterhalb der n-dotierten Gitterstruktur in dem porös geätzten Substratbereich eine Kaverne und mindestens ein in die Kaverne mündender Kanal erzeugt, so dass mindestens eine Zugangsöffnung in der Gitterstruktur über dem Kanal angeordnet ist. Damit lassen sich in einfacher Weise vollständig monokristalline Membranen erzeugen, was nachfolgend in Verbindung mit einem Ausführungsbeispiel nochmals näher erläutert wird.

Schließlich sei an dieser Stelle noch darauf hingewiesen, dass sich das erfindungsgemäße Verfahren nicht nur sehr gut zur Herstellung von mikromechanischen Relativdruck- und Absolutdrucksensoren eignet, sondern beispielsweise auch zur Herstellung von mikromechanischen Mikrofonelementen.

### Kurze Beschreibung der Zeichnungen

Wie bereits voranstehend erörtert, gibt es verschiedene Möglichkeiten, die Lehre der vorliegenden Erfindung in vorteilhafter Weise auszugestalten und weiterzubilden. Dazu wird einerseits auf die dem unabhängigen Patentanspruch 1 nachgeordneten Patentansprüche und andererseits auf die nachfolgende Beschreibung mehrerer Ausführungsbeispiele der Erfindung anhand der Zeichnungen verwiesen.
- **Fig. 1a - 1i**: veranschaulichen die einzelnen Verfahrensschritte einer ersten Variante des erfindungsgemäßen Verfahrens anhand schematischer Schnittansichten einer ersten Bauelementstruktur während der Herstellung;
- **Fig. 2**: zeigt eine Variante des in den Fig. 1f-g dargestellten Aufwachsens einer zweiten Epitaxieschicht;
- **Fig. 3**: veranschaulicht eine Variante des in den Figuren 1 dargestellten Verfahrens, bei der auf das Aufwachsen einer zweiten Epitaxieschicht verzichtet wird;
- **Fig. 4a - 4c**: veranschaulichen verschiedene Lochanordnungen in der n-dotierten Gitterstruktur durch entsprechende Draufsichten auf ein Siliziumsubstrat;
- **Fig. 5**: zeigt eine schematische Draufsicht auf eine Bauelementstruktur nach dem Erzeugen einer Kaverne mit einem Stichkanal und nach dem Aufwachsen einer ersten Epitaxieschicht - diese Draufsicht umfasst drei Schnittachsen A, B und C;
- **Fig. 6a - 6c**: zeigen jeweils eine Schnittdarstellung durch die in Fig. 5 dargestellte Bauelementstruktur entlang der Schnittachsen A, B und C nach dem Aufwachsen der ersten Epitaxieschicht;
- F**ig. 7a - 7c**: zeigen jeweils eine Schnittdarstellung durch die in Fig. 5 dargestellte Bauelementstruktur entlang der Schnittachsen A, B und C nach dem Oxidationsprozess;
- **Fig. 8a - 8c**: zeigen jeweils eine Schnittdarstellung durch die in Fig. 5 dargestellte Bauelementstruktur entlang der Schnittachsen A, B und C nach dem oberflächlichen Entfernen der Oxidschicht;
- **Fig. 9a - 9c**: zeigen jeweils eine Schnittdarstellung durch die in Fig. 5 dargestellte Bauelementstruktur entlang der Schnittachsen A, B und C nach dem Aufwachsen einer zweiten Epitaxieschicht.

### Ausführungsformen der Erfindung

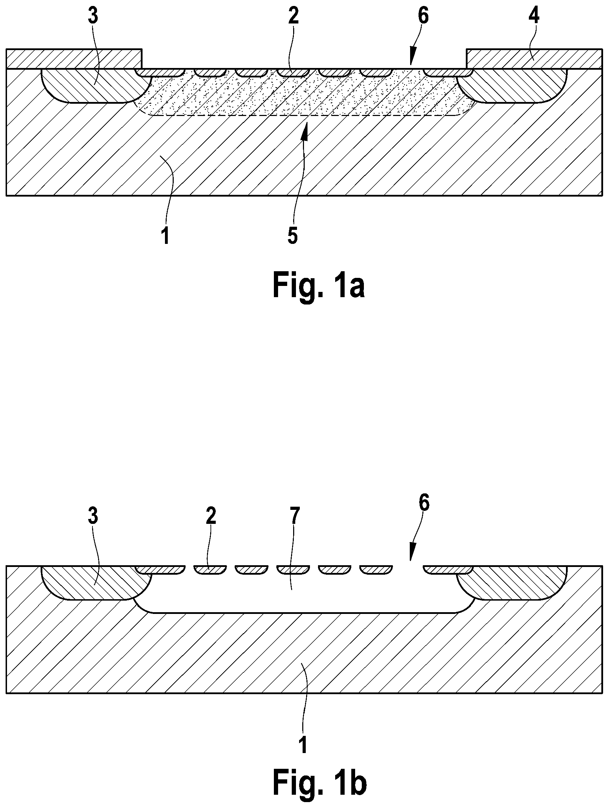

Das erfindungsgemäße Verfahren zur Herstellung einer mikromechanischen Membranstruktur mit Zugang von der Substratrückseite geht von einem p-dotierten Si-Substrat 1 aus. Bei der in Fig. 1a bis 1i dargestellten Verfahrensvariante wurde zunächst ein n-dotierter, zusammenhängender gitterförmiger Bereich 2 in der Substratoberfläche erzeugt, beispielsweise durch Implantation oder Diffusion. Außerdem wurde ein sich mehr in die Tiefe des Substrats 1 erstreckender n⁺-dotierter Bereich 3 erzeugt, der den eher oberflächlichen gitterförmigen Bereich 2 umgibt. Die so präparierte Substratoberfläche wurde dann mit einer SiN-Maske 4 versehen, die die lateralen Abmessungen eines Substratbereichs 5 unterhalb der n-dotierten Gitterstruktur 2 festlegt. In einem anschließenden Verfahrensschritt - beispielsweise Anodisierung des Siliziums in konzentrierter Flusssäure - wurde das Silizium im Substratbereich 5 porös geätzt. Dabei schützt die SiN-Maske die Substratoberfläche, insbesondere im Umgebungsbereich der zu erzeugenden Membran, der z.B. zur monolithischen Integration einer Auswerteschaltung genutzt werden kann. Die tiefe seitliche n⁺-Dotierung 3 bildet einen lateralen Ätzstopp für diesen Ätzschritt. Auch die n-dotierte Gitterstruktur 2 wird nicht angegriffen, sie dient als Startschicht für eine spätere Epitaxie. **Fig. 1a** zeigt das prozessierte Siliziumsubstrat 1 nach dem porös Ätzen des Substratbereichs 5. Aus dieser Fig. 1a ist auch ersichtlich, dass zumindest eine Öffnung 6 der n-dotierten Gitterstruktur 2 größer als die den Gittercharakter bestimmende Maschengröße ausgelegt ist. Während diese Maschengröße so gewählt wurde, dass die Maschen in einem nachfolgenden Epitaxieprozess verschlossen werden, wurde die Größe der Öffnung 6 so bestimmt, dass sie durch die aufwachsende Epitaxieschicht nicht verschlossen wird, sondern eine Zugangsöffnung zu dem Bereich 5 bildet.

Vor diesem Epitaxieprozesses wird die SiN-Maske 4 von der Substratoberfläche entfernt. Außerdem wird in dem porös geätzten Substratbereich 5 unterhalb der n-dotierten Gitterstruktur 2 eine Kaverne 7 erzeugt. Dazu kann das poröse Silizium beispielsweise nasschemisch herausgelöst werden. Die Kaverne 7 kann aber auch in einem Temperschritt durch thermische Umlagerung des porösen Siliziums erzeugt werden. Eine weitere Option besteht darin, gleich zu Beginn durch Elektropolitur poröses Silizium mit einer Porosität von 100% im Substratbereich 5 zu erzeugen. **Fig. 1b** veranschaulicht, dass die Öffnung 6 im Bereich über der Kaverne 7 angeordnet ist.

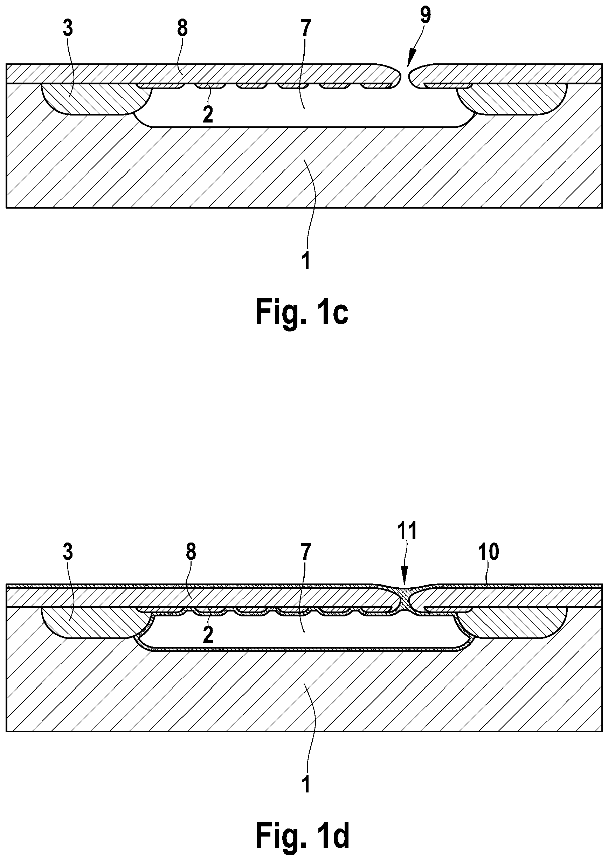

**Fig. 1c** stellt das Aufwachsen einer ersten monokristallinen Silizium-Epitaxieschicht 8 auf der n-dotierten Gitterstruktur 2 dar. Die Dicke der Epitaxieschicht 8 ist an die Maschengröße der Gitterstruktur 2 und an die Größe der Öffnung 6 angepasst, indem die Maschen der Gitterstruktur 2 überwachsen wurden, während die Öffnung 6 nicht geschlossen wurde. An dieser Stelle hat sich eine Zugangsöffnung 9 in der Epitaxieschicht 8 gebildet.

Erfindungsgemäß wird nun eine Oxidschicht 10 auf der Kavernenwandung erzeugt. Dies erfolgt vorzugsweise durch thermische Oxidation, kann aber auch durch konforme Abscheidung von Siliziumoxid auf der Epitaxieschicht 8 realisiert werden. In diesem Fall dringt das Siliziumoxid über die Zugangsöffnung 9 in die Kaverne 7 ein und kleidet diese aus. Bei dem hier dargestellten Ausführungsbeispiel - siehe insbesondere **Fig. 1d** - wurde der Oxidationsprozess solange fortgeführt, bis die Zugangsöffnung 9 zugewachsen war, so dass die Kaverne 7 durch einen Oxidpfropf 11 abgeschlossen ist.

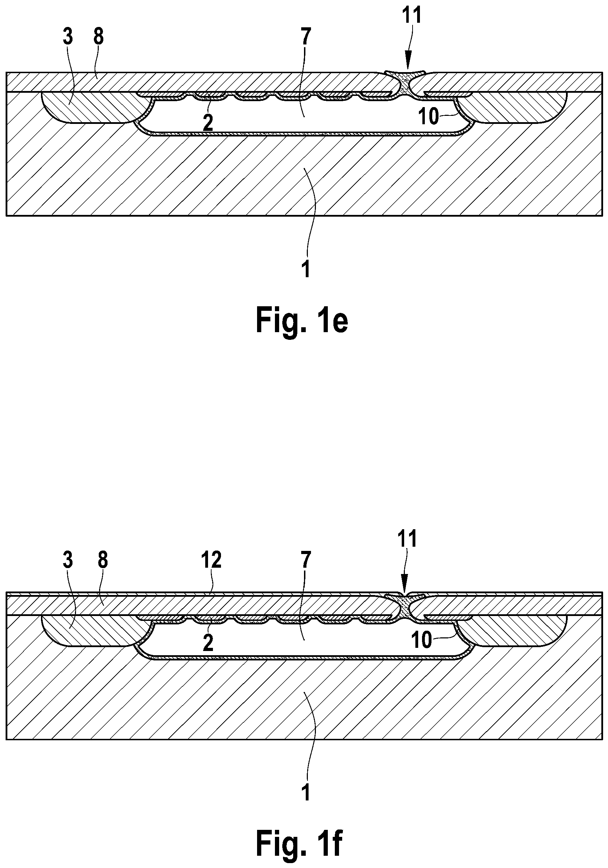

Dann wurde die Oxidschicht 10 von der Oberfläche der ersten Epitaxieschicht 8 entfernt, was in **Fig. 1e** dargestellt ist. Die so freigelegte monokristalline erste Epitaxieschicht 8 kann nun als Startschicht für einen weiteren Epitaxieprozess genutzt werden.

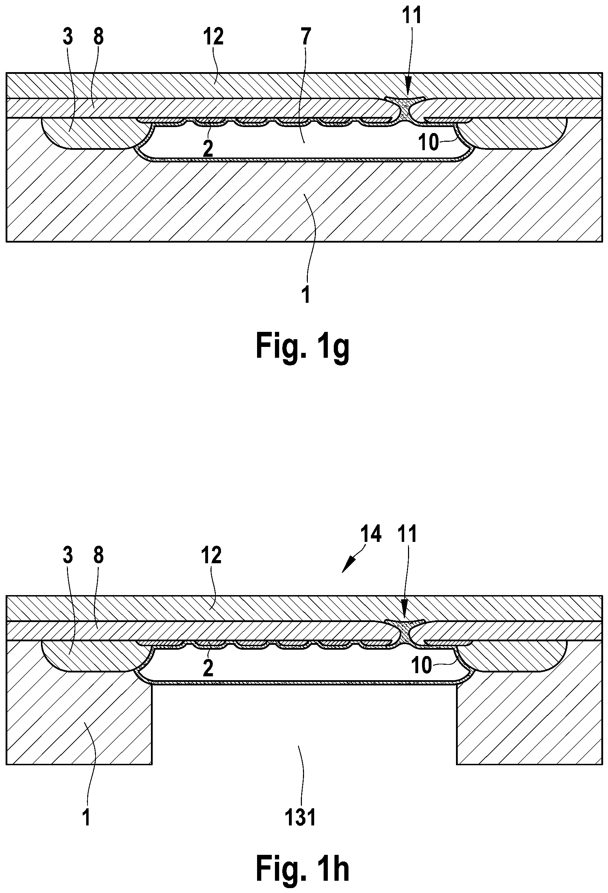

Das Wachstum einer dabei entstehenden zweiten monokristallinen Epitaxieschicht 12 auf der ersten Epitaxieschicht 8 ist in **Fig. 1f** und **Fig. 1g** dargestellt. Die Prozessführung ist hier so ausgelegt, dass die Entstehung von polykristallinem Silizium über dem Oxidpfropf 11 vermieden wird. Der Oxidpfropf 11 wird hier lateral einkristallin überwachsen. Fig. 1f zeigt den Wachstumsprozess zu einem Zeitpunkt kurz bevor sich die beiden Siliziumfronten über dem Oxidpfropf 11 treffen. Fig. 1g veranschaulicht den Fortgang des Epitaxieprozesses bis die vollständige Membrandicke erreicht ist.

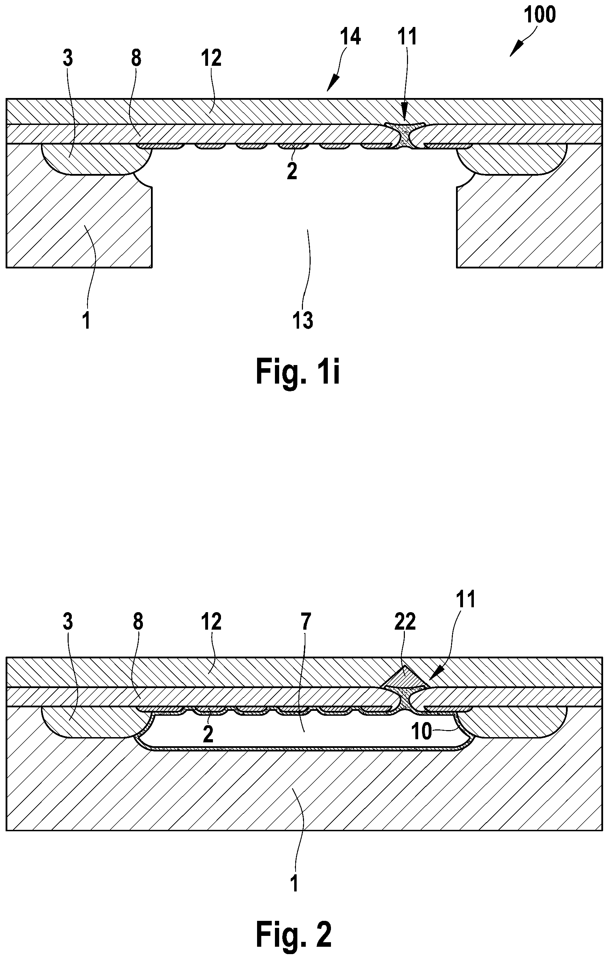

Nach diesen rein oberflächenmikromechanischen Verfahrensschritten wird die Substratrückseite strukturiert, um einen Rückseitenzugang 13 zur Kaverne 7 zu erzeugen. Erfindungsgemäß wird hierfür ein Ätzverfahren, wie z.B. Trenchen oder KOH-Ätzen, eingesetzt, bei dem die Oxidschicht 10 auf der Kavernenwandung als Ätzstoppschicht fungiert. Im vorliegenden Ausführungsbeispiel wird zunächst ein Trenchzugang 131 erzeugt, dessen laterale Ausdehnung dementsprechend kleiner ist als die laterale Ausdehnung der Kaverne 7. Die Oxidschicht 10 dient so auch als Schutz der einkristallinen Membran 14 oberhalb der Kaverne gegen Durchätzen. **Fig. 1h** zeigt die Bauelementstruktur nach dem Trenchprozess. Die Oxidschicht 10 ist hier noch vorhanden. Sie wird erst in einem weiteren Prozessschritt entfernt, um den Rückseitenzugang 13 endgültig zu öffnen. Dies erfolgt von der Substratrückseite ausgehend, beispielsweise durch HF-Gasphasenätzen oder auch nasschemisch. Die resultierende Bauelementstruktur 100 ist in **Fig. 1i** dargestellt. Wie voranstehend erläutert, ist die laterale Ausdehnung der Kaverne unter der Membranstruktur 14 verfahrensbedingt allseitig größer als die Mündungsöffnung des Rückseitenzugangs 13 in der Kavernenwandung.

**Fig. 2** veranschaulicht eine Variante der in Verbindung mit den Figuren 1f und 1g erläuterten Prozessführung zum Aufwachsen einer zweiten Epitaxieschicht 12 auf der ersten Epitaxieschicht 8, bei der der Oxidpfropf 11 nicht ausschließlich lateral mit monokristallinem Silizium überwachsen wird. Vielmehr wächst hier zunächst sowohl monokristallines Silizium 12 auf der ersten Epitaxieschicht 8 als auch polykristallines Silizium 22 auf dem Oxidpfropf 11 auf. Jedoch werden die Prozessparameter so gewählt, dass die Wachstumsrate des einkristallinen Siliziums höher ist als die des polykristallinen Siliziums. Dadurch wird der polykristalline Bereich 22 mit zunehmender Epitaxiedicke immer kleiner, bis er schließlich vollständig von monokristallinem Silizium überwachsen ist, was in Fig. 2 dargestellt ist. Alternativ kann auch auf dem thermischen Oxid (Fig. 1d), als Epitaxie-Startschicht, ganzflächig eine polykristalline Si-Schicht (z.B. Start-Poly) abgeschieden und anschließend über eine Photolithographie-Ebene zusammen mit dem Oxid strukturiert werden.

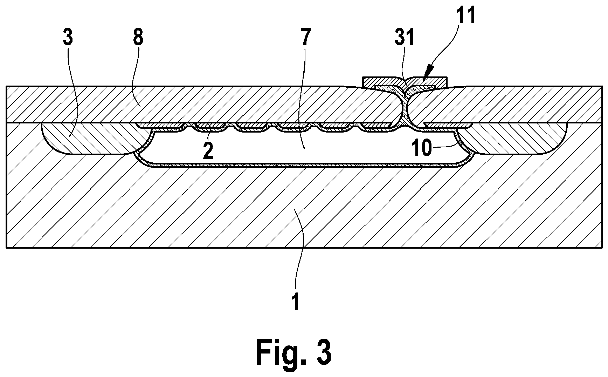

Eine zweite Epitaxieschicht 12, wie in den Figuren 1 und 2 dargestellt, ist zur Realisierung eines Membranverschlusses nicht zwingend erforderlich. Dies wird durch **Fig. 3** veranschaulicht. Der Verschluss der Zugangsöffnung 9 in der Epitaxieschicht 8 wird hier ausschließlich durch dielektrische oder polykristalline Schichten gebildet, nämlich durch die Oxidschicht 10 bzw. den Oxidpfropf 11. Dieser wurde hier durch eine Silizium-Nitrid-Schicht 31 ergänzt, um die Langzeitdichtigkeit des Pfropf 11 zu erhöhen und um das Oxid gegen einen Ätzangriff im Verlauf der weiteren Prozessierung zu schützen. Bei dieser Variante wurde auf das Aufwachsen einer weiteren Epitaxieschicht verzichtet.

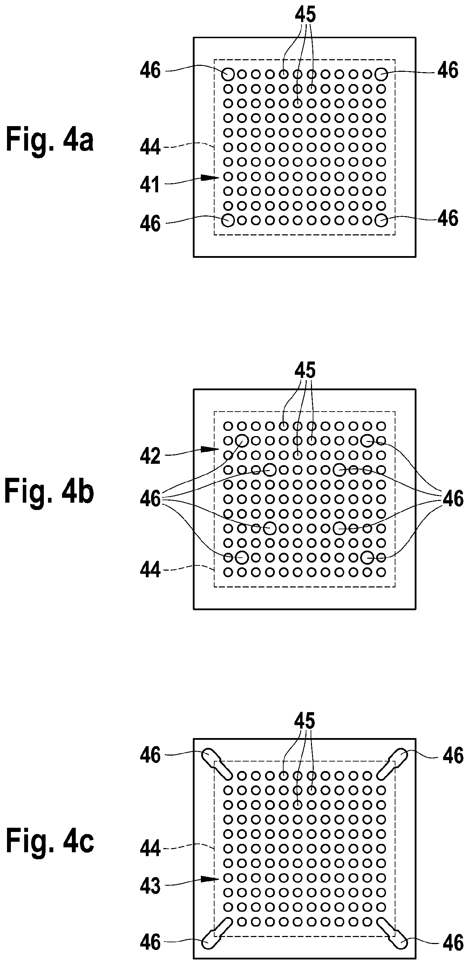

Die Figuren 4a bis 4c zeigen drei verschiedene Lochanordnungen in drei quadratischen n-dotierten Gitterstrukturen 41, 42 und 43. Der spätere Membran- bzw. Kavernenbereich ist jeweils durch die gestrichelte Linie 44 angedeutet. Die Größe der Gittermaschen 45 ist jeweils so gewählt worden, dass sie in dem nachfolgenden Epitaxieprozess einkristallin überwachsen und damit verschlossen werden. Im Unterschied dazu bilden die größeren Öffnungen 46 auch noch nach diesem Epitaxieprozess Zugangsöffnungen zur Kaverne, die erst nach der Oxidation der Kavernenwandung verschlossen werden. Die Gittermaschen 45 können nicht nur quadratisch, wie hier dargestellt, angeordnet sein, sondern beispielsweise auch hexagonal, diagonal oder zentrosymmetrisch. Für die Anordnung der Öffnungen 46 gelten ähnliche Freiheitsgrade, dabei kann auch die Anzahl der Öffnungen 46 je nach Größe und Geometrie der Membran gewählt werden. Vorteilhafterweise werden die Öffnungen 46 in den Eckbereichen der Membran angeordnet, da hier günstigere Stressverhältnisse vorherrschen. Ähnliche Überlegungen gelten für andere Membrangeometrien.

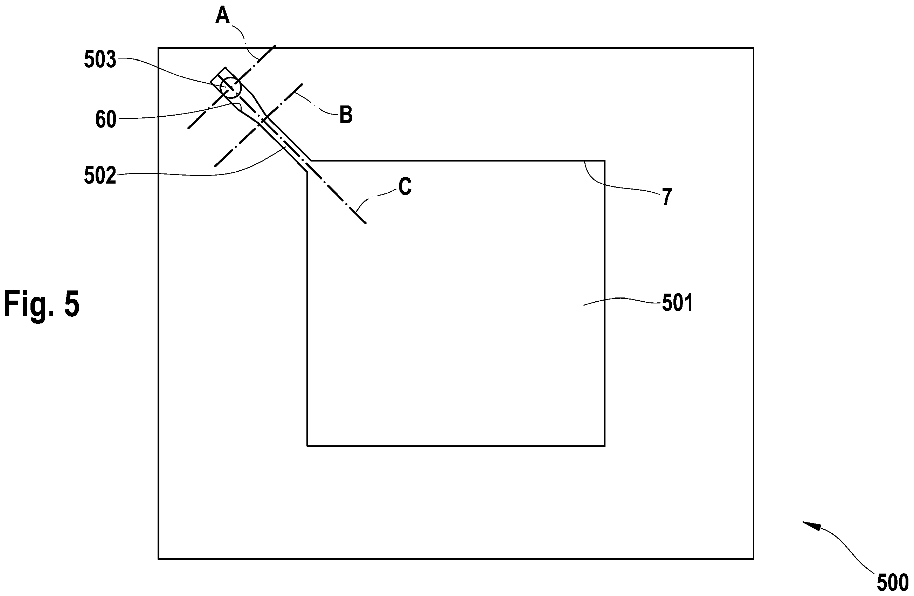

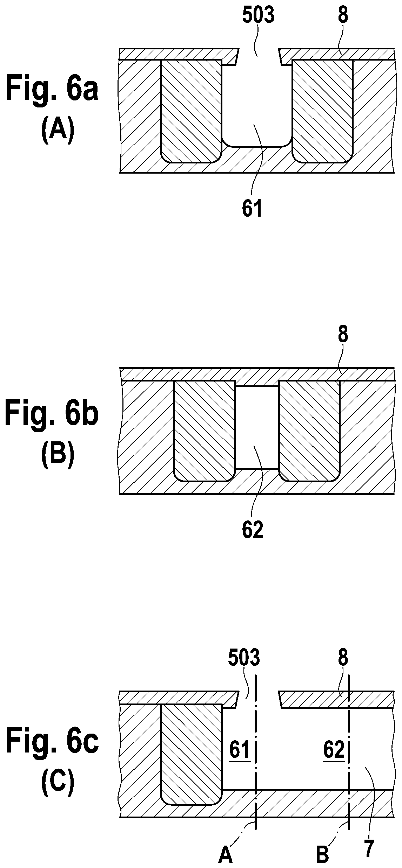

Die Figuren 5 bis 9 veranschaulichen eine Variante des erfindungsgemäßen Verfahrens, die sich von der in den Figuren 1a bis 1i dargestellten Variante im Wesentlichen in der Form der Membran bzw. der Anordnung der Zugangsöffnungen unterscheidet. Dies wird insbesondere durch **Fig. 5** verdeutlicht, die eine schematische Draufsicht auf eine Bauelementstruktur 500 nach dem Aufwachsen der ersten Epitaxieschicht zeigt. Der quadratische Membranbereich ist mit 501 bezeichnet. Unter dem Membranbereich 501 befindet sich eine Kaverne 7 im Siliziumsubstrat. In die Kaverne 7 mündet ein trichterförmiger Stichkanal 60, der zusammen mit der Kaverne 7 durch entsprechende Auslegung der n-dotierten Gitterstruktur und des darunter ausgebildeten porösen Siliziumbereichs erzeugt worden ist und in den Figuren 6 bis 9 dargestellt ist. Der Bereich der Epitaxieschicht über diesem Stichkanal 60 ist mit 502 bezeichnet. Im hier dargestellten Ausführungsbeispiel ist die Zugangsöffnung 503 am erweiterten Ende dieses Bereichs 502 angeordnet. Die Konsequenzen und Vorteile dieser Anordnung der Zugangsöffnung 503 im Kanalbereich werden anhand der Schnittansichten A, B und C der Figuren 6 bis 9 erläutert.

Die Figuren 6a bis 6c zeigen die Bauelementstruktur 500 im selben Verfahrensstadium wie Fig. 5, nämlich nach dem Aufwachsen der ersten Epitaxieschicht 8 auf der n-dotierten Gitterstruktur und der Substratoberfläche. Die Gittermaschen der monokristallinen Gitterstruktur wurden monokristallin überwachsen. Lediglich im Bereich der Öffnung am trichterförmigen Ende 61 des Kanals 60 hat sich eine Zugangsöffnung 503 in der Epitaxieschicht 8 gebildet, was in **Fig. 6a** dargestellt ist. Im sich verjüngenden Bereich 62 des Kanals 60 ist die Epitaxieschicht 8 geschlossen, wie auch im übrigen Membranbereich, was aus **Fig. 6b** und **Fig. 6c** ersichtlich ist.

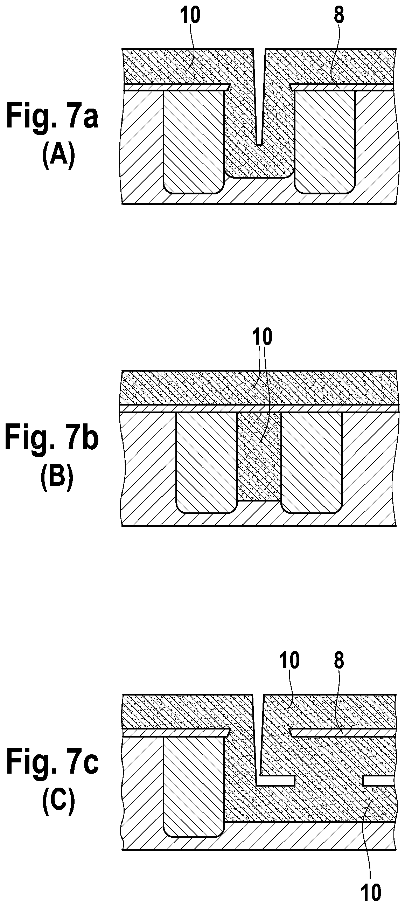

Die Figuren 7a bis 7c geben die Situation nach dem Oxidationsprozess wieder. Dabei wächst das Oxid 10 solange mit gleichmäßiger Schichtdicke auf, bis sich der Kanal 60 im sich verjüngenden Bereich 62 verschließt, was in **Fig. 7b** dargestellt ist. Dadurch wird die Sauerstoffzufuhr in die Kaverne unterbunden, so dass auch hier kein weiteres Oxid mehr aufwachsen kann. Am trichterförmigen Ende 61 des Kanals 60 ist jedoch ein weiteres Aufwachsen von Oxid 10 möglich, so dass sich der Kanal 60 über einen großen Bereich vollständig schließt, wie in **Fig. 7a** und **Fig. 7c** dargestellt.

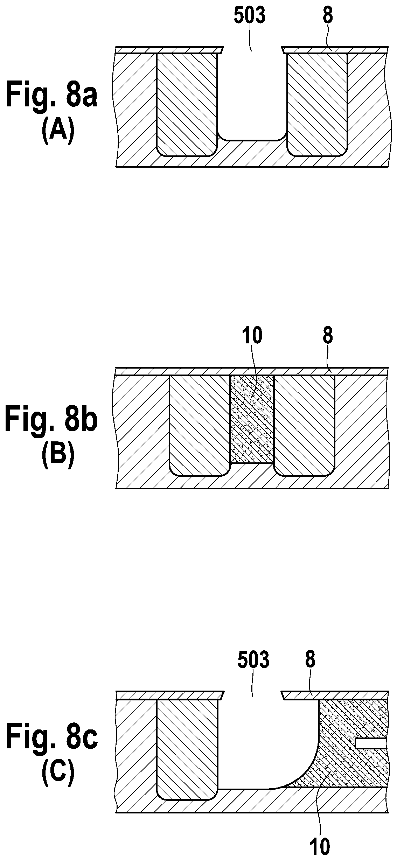

In den **Figuren 8a bis 8c** ist die Bauelementstruktur 500 nach dem oberflächlichen Entfernen der Oxidschicht 10 dargestellt. Dazu kann ein nasschemischer Ätzprozess, Gasphasenätzen oder auch ein anisotroper Plasmaätzprozess verwendet werden. Die Dicke der zu ätzenden oberflächlichen Oxidschicht 10 ist wesentlich geringer als die Länge des zugewachsenen Kanals 60. Im hier dargestellten Ausführungsbeispiel wird beim Ätzen der Oxidschicht 10 deshalb lediglich das Oxid im Bereich der Zugangsöffnung 503 entfernt, während der Kanal 60 weiterhin verschlossen bleibt.

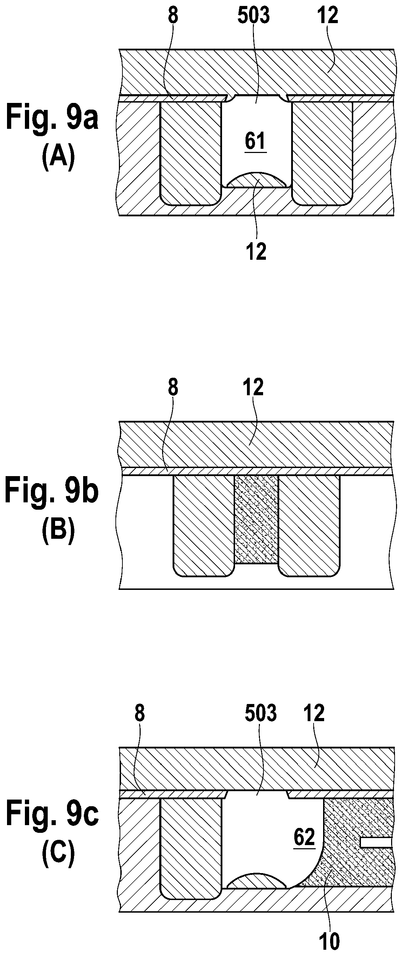

Die **Figuren 9a bis 9c** zeigen die Bauelementstruktur 500 schließlich nach dem Aufwachsen einer zweiten monokristallinen Epitaxieschicht 12, die nicht nur den Membranbereich vollständig bedeckt - siehe Fig. 9c -, sondern auch den Kanalbereich 61 mit der Zugangsöffnung 503 - siehe Fig. 9a - und den Kanalbereich 62, was in Fig. 9c dargestellt ist. Da das Oxid 10 im gesamten Bereich der Zugangsöffnung 503 entfernt worden ist, konnte die Epitaxieschicht 12 auf dem einkristallinen Boden des Kanalbereichs 61 und auf der Seitenwandung der Zugangsöffnung 503 aufwachsen.

## Patentansprüche

1. Verfahren zur Herstellung einer mikromechanischen Membranstruktur mit Zugang von der Substratrückseite, wobei das Verfahren von einem p-dotierten Si-Substrat (1) ausgeht und die folgenden Prozessschritte umfasst:
- n-Dotierung mindestens eines zusammenhängenden gitterförmigen Bereichs (2) der Substratoberfläche,
- porös Ätzen eines Substratbereichs (5) unterhalb der n-dotierten Gitterstruktur (2),
- Erzeugen einer Kaverne (7) in diesem Substratbereich (5) unterhalb der n-dotierten Gitterstruktur (2);
- Aufwachsen einer ersten monokristallinen Silizium-Epitaxieschicht (8) auf der n-dotierten Gitterstruktur (2);
**dadurch gekennzeichnet,**
- **dass** mindestens eine Öffnung (6) der n-dotierten Gitterstruktur (2) so dimensioniert wird, dass sie durch die aufwachsende erste Epitaxieschicht (8) nicht verschlossen wird sondern eine Zugangsöffnung (9) zu der Kaverne (7) bildet;
- **dass** auf der Kavernenwandung eine Oxidschicht (10) erzeugt wird;
- **dass** ein Trenchzugang (131) zur Kaverne (7) erzeugt wird, wobei die Oxidschicht (10) auf der Kavernenwandung als Ätzstoppschicht für eine aus der ersten monokristallinen Silizium-Epitaxieschicht (8) gebildeten Membranstruktur (14) oberhalb der Kaverne (7) dient; und
- **dass** die Oxidschicht (10) im Bereich der Kaverne (7) nach der Aufwachsen der ersten Silizium-Epitaxieschicht (8) entfernt wird so dass durch den Trenchzugang (131) ein Rückseitenzugang (13) zu der über der Kaverne (7) ausgebildeten Membranstruktur (14) entsteht.

2. Verfahren nach Anspruch 1, **dadurch gekennzeichnet, dass** die Oxidschicht (10) auf der Kavernenwandung durch thermische Oxidation erzeugt wird, wobei die dafür erforderliche Sauerstoffzufuhr über die Zugangsöffnung (9) erfolgt.

3. Verfahren nach Anspruch 2, **dadurch gekennzeichnet, dass** die thermische Oxidation zumindest solange fortgesetzt wird, bis die Zugangsöffnung (9) verschlossen ist.

4. Verfahren nach einem der Ansprüche 1 oder 2, dass die Zugangsöffnung (9) durch Abscheiden mindestens einer dielektrischen, polykristallinen oder epitaktischen Schicht, insbesondere einer Oxidschicht, auf der ersten Epitaxieschicht (8) verschlossen wird.

5. Verfahren nach einem der Ansprüche 1 bis 4, **dadurch gekennzeichnet, dass** auf der ersten Epitaxieschicht (8) mindestens eine weitere Silizium-Epitaxieschicht (12) erzeugt wird, die die verschlossene Zugangsöffnung (9) überdeckt.

6. Verfahren nach Anspruch 5, **dadurch gekennzeichnet, dass** die Prozessparameter beim Erzeugen der weiteren Silizium-Epitaxieschicht (12) so gewählt werden, dass über der verschlossenen Zugangsöffnung (9) ein polykristalliner Bereich (22) entsteht, der von monokristallinem Silizium überwachsen wird.

7. Verfahren nach Anspruch 5, **dadurch gekennzeichnet, dass** die Prozessparameter beim Erzeugen der weiteren Silizium-Epitaxieschicht (12) so gewählt werden, dass die verschlossene Zugangsöffnung (9) lateral von monokristallinem Silizium überwachsen wird, so dass die weitere Silizium-Epitaxieschicht (12) durchgängig monokristallin ist.

8. Verfahren nach einem der Ansprüche 1 bis 7, **dadurch gekennzeichnet, dass** unterhalb der n-dotierten Gitterstruktur (2) in dem porös geätzten Substratbereich (5) eine Kaverne (7) und mindestens ein in die Kaverne (7) mündender Kanal (60) erzeugt wird und dass mindestens eine Zugangsöffnung (503) in der Gitterstruktur über dem Kanal (60) angeordnet wird.

9. Halbleiternauelement (100) hergestellt nach dem Verfahren zur Herstellung einer mikromechanischen Membranstruktur mit Zugang von der Substratrückseite nach Anspruch 1 mit einer mikromechanischen Membranstruktur (14) über einer Kaverne (7) in einem p-dotierten Si-Substrat (1) und mit einem Rückseitenzugang (13) zur Kaverne, wobei die Membranstruktur eine n-dotierte Gitterstruktur (2) umfasst, auf der mindestens eine erste Epitaxieschicht (8) aufgewachsen ist, wobei die laterale Ausdehnung der Kaverne (7) unter der Membranstruktur allseitig größer ist als die Mündungsöffnung des Rückseitenzugangs (13) in der Kavernenwandung, **dadurch gekennzeichnet dass** mindestens eine Öffnung der n-dotierten Gitterstruktur (2) größer als die den Gittercharakter bestimmende Maschengröße ist und so bestimmt wurde, dass sie durch die aufwachsende Epitaxieschicht nicht verschlossen wird.

## Claims

1. Method for producing a micromechanical membrane structure having access from the substrate rear side, wherein the method proceeds from a p-doped Si substrate (1) and comprises the following process steps:
- n-type doping of at least one continuous lattice-shaped region (2) of the substrate surface,
- etching in a porous fashion a substrate region (5) below the n-doped lattice structure (2),
- producing a cavity (7) in said substrate region (5) below the n-doped lattice structure (2);
- growing a first monocrystalline silicon epitaxial layer (8) on the n-doped lattice structure (2); **characterized**
- **in that** at least one opening (6) of the n-doped lattice structure (2) is dimensioned such that it is not closed by the growing first epitaxial layer (8), but rather forms an access opening (9) to the cavity (7) ;
- **in that** an oxide layer (10) is produced on the cavity wall;
- **in that** a trench access (131) to the cavity (7) is produced, wherein the oxide layer (10) on the cavity wall serves as an etch stop layer for a membrane structure (14) above the cavity (7), said membrane structure being formed from the first monocrystalline silicon epitaxial layer (8); and
- **in that** the oxide layer (10) in the region of the cavity (7) is removed after the first silicon epitaxial layer (8) has been grown, such that a rear-side access (13) to the membrane structure (14) formed above the cavity (7) arises through the trench access (131).

2. Method according to Claim 1, **characterized in that** the oxide layer (10) is produced on the cavity wall by thermal oxidation, wherein the supply of oxygen required for this purpose is effected via the access opening (9).

3. Method according to Claim 2, **characterized in that** the thermal oxidation is continued at least until the access opening (9) is closed.

4. Method according to either of Claims 1 and 2, **characterized in that** the access opening (9) is closed by the deposition of at least one dielectric, polycrystalline or epitaxial layer, in particular an oxide layer, on the first epitaxial layer (8).

5. Method according to any of Claims 1 to 4, **characterized in that** at least one further silicon epitaxial layer (12) is produced on the first epitaxial layer (8), said at least one further silicon epitaxial layer covering the closed access opening (9).

6. Method according to Claim 5, **characterized in that** the process parameters when producing the further silicon epitaxial layer (12) are chosen such that a polycrystalline region (22) arises above the closed access opening (9), said polycrystalline region being overgrown by monocrystalline silicon.

7. Method according to Claim 5, **characterized in that** the process parameters when producing the further silicon epitaxial layer (12) are chosen such that the closed access opening (9) is laterally overgrown by monocrystalline silicon, such that the further silicon epitaxial layer (12) is monocrystalline throughout.

8. Method according to any of Claims 1 to 7, **characterized in that** below the n-doped lattice structure (2) in the substrate region (5) etched in a porous fashion a cavity (7) is produced and at least one channel (60) leading into the cavity (7) is produced, and **in that** at least one access opening (503) is arranged in the lattice structure above the channel (60).

9. Semiconductor component (100) produced according to the method for producing a micromechanical membrane structure having access from the substrate rear side according to Claim 1, comprising a micromechanical membrane structure (14) above a cavity (7) in a p-doped Si substrate (1) and comprising a rear-side access (13) to the cavity, wherein the membrane structure comprises an n-doped lattice structure (2), on which at least one first epitaxial layer (8) is grown,
wherein the lateral extent of the cavity (7) below the membrane structure is larger on all sides than the orifice opening of the rear-side access (13) in the cavity wall,
**characterized in that**
at least one opening of the n-doped lattice structure (2) is larger than the mesh size determining the lattice character and was determined such that it is not closed by the growing epitaxial layer.

## Revendications

1. Procédé pour produire une structure membranaire micromécanique comportant un accès par le côté arrière du substrat, dans lequel le procédé part d'un substrat de Si à dopage p (1) et comprend les opérations suivantes:
- dopage n d'au moins une zone continue en forme de réseau (2) de la surface du substrat,
- décapage poreux d'une zone du substrat (5) en dessous de la structure de réseau à dopage n (2),
- production d'une caverne (7) dans cette zone du substrat (5) en dessous de la structure de réseau à dopage n (2);
- croissance d'une première couche épitaxiale de Si monocristallin (8) sur la structure de réseau à dopage n (2);
**caractérisé en ce que**
- on dimensionne au moins une ouverture (6) de la structure de réseau à dopage n (2) de telle manière qu'elle ne soit pas fermée par la première couche épitaxiale croissante (8) mais qu'elle forme une ouverture d'accès (9) à la caverne (7);
- on produit une couche d'oxyde (10) sur la paroi de la caverne;
- on produit un accès en tranchée (131) à la caverne (7), dans lequel la couche d'oxyde (10) sur la paroi de la caverne fait office de couche d'arrêt de décapage pour une structure membranaire (14) formée de la première couche épitaxiale de silicium monocristallin (8) au-dessus de la caverne (7); et
- on enlève la couche d'oxyde (10) dans la région de la caverne (7) après la croissance de la première couche épitaxiale de silicium (8), de telle manière qu'il existe par l'accès en tranchée (131) un accès par le côté arrière (13) à la structure membranaire (14) formée au-dessus de la caverne (7).

2. Procédé selon la revendication 1, **caractérisé en ce que** l'on produit la couche d'oxyde (10) sur la paroi de la caverne par oxydation thermique, dans lequel l'apport d'oxygène nécessaire à cet effet est effectué par l'ouverture d'accès (9).

3. Procédé selon la revendication 2, **caractérisé en ce que** l'on poursuit l'oxydation thermique au moins jusqu'à ce que l'ouverture d'accès (9) soit fermée.

4. Procédé selon une des revendications 1 ou 2, **caractérisé en ce que** l'on ferme l'ouverture d'accès (9) par dépôt d'au moins une couche diélectrique, polycristalline ou épitaxiale, en particulier une couche d'oxyde, sur la première couche épitaxiale (8).

5. Procédé selon l'une quelconque des revendications 1 à 4, **caractérisé en ce que** l'on produit sur la première couche épitaxiale (8) au moins une autre couche épitaxiale de silicium (12), qui recouvre l'ouverture d'accès fermée (9).

6. Procédé selon la revendication 5, **caractérisé en ce que** l'on choisit les paramètres du processus lors de la production de l'autre couche épitaxiale de silicium (12), de telle manière qu'il existe au-dessus de l'ouverture d'accès fermée (9) une région polycristalline (22), qui est recouverte par croissance de silicium monocristallin.

7. Procédé selon la revendication 5, **caractérisé en ce que** l'on choisit les paramètres du processus lors de la production de l'autre couche épitaxiale de silicium (12), de telle manière que l'ouverture d'accès fermée (9) soit recouverte latéralement par croissance de silicium monocristallin, de telle manière que l'autre couche épitaxiale de silicium (12) soit de façon continue monocristalline.

8. Procédé selon l'une quelconque des revendications 1 à 7, **caractérisé en ce que** l'on produit en dessous de la structure de réseau à dopage n (2) une caverne (7) dans la zone du substrat décapée poreuse (5) et au moins un canal (60) débouchant dans la caverne (7), et **en ce que** l'on dispose au moins une ouverture d'accès (503) dans la structure de réseau au-dessus du canal (60).

9. Elément semi-conducteur (100) fabriqué par le procédé pour produire une structure membranaire micromécanique comportant un accès par le côté arrière du substrat selon la revendication 1 avec une structure membranaire micromécanique (14) au-dessus d'une caverne (7) dans un substrat de Si à dopage p (1) et avec un accès par le côté arrière (13) à la caverne (7), dans lequel la structure membranaire comprend une structure de réseau à dopage n (2), sur laquelle au moins une première couche épitaxiale (8) a été formée par croissance, dans lequel l'extension latérale de la caverne (7) en dessous de la structure membranaire est de tous côtés plus grande que l'ouverture de l'embouchure de l'accès par le côté arrière (13) dans la paroi de la caverne, **caractérisé en ce qu'**au moins une ouverture de la structure de réseau à dopage n (2) est plus grande que la grandeur des mailles définissant le caractère de réseau et a été déterminée de telle manière qu'elle ne soit pas fermée par la couche épitaxiale croissante.
